# DEMANDE DE BREVET EUROPEEN

(11) **EP 3 226 393 A1**
(43) Date de publication de la demande: **04.10.2017**
(21) Numéro de dépôt: 17164246.5
(22) Date de dépôt: 31.03.2017
(51) Int. Cl.: H02M 1/088, H03K 17/16, H03K 17/12, H02M 7/5387

(54) **CONVERTISSEUR D'ÉNERGIE ÉLECTRIQUE, CHAÎNE DE TRACTION COMPORTANT UN TEL CONVERTISSEUR ET VÉHICULE ÉLECTRIQUE DE TRANSPORT ASSOCIÉ**

(30) Priorité: 01.04.2016 FR 1652865
(71) Demandeur: ALSTOM Transport Technologies, 93400 Saint-Ouen (FR)
(72) Inventeur: LEPAGE, Jean-Pierre, 65460 BOURS (FR)
(74) Mandataire: Lavoix

(57) **Abrégé**

Ce convertisseur d'énergie électrique (30) d'une première énergie en une deuxième énergie, comprend deux premières bornes (36) pour la première énergie, au moins une deuxième borne (38) pour la deuxième énergie, P bras de commutation (40), chacun comportant deux demi-bras de commutation (42) connectés en série entre les deux premières bornes (36) et reliés entre eux en un point intermédiaire (44) relié à une deuxième borne (38) respective. Chaque demi-bras (42) comporte N demi-branches de commutation (46) connectées en parallèle, N ≥ 2, chaque demi-branche (46) comportant un interrupteur (48).

Ce convertisseur comprend en outre 2xP modules de commande (50), chaque module de commande (50) étant configuré pour commander les interrupteurs (48) d'un demi-bras (42) respectif, chaque module de commande (50) comportant une borne de sortie (52) pour chaque interrupteur (48) respectif, chaque borne de sortie (52) étant configurée pour délivrer un signal de commande pour ledit interrupteur (48) respectif.

## Description

La présente invention concerne un convertisseur d'énergie électrique configuré pour convertir une première énergie électrique en une deuxième énergie électrique.

L'invention concerne également une chaîne de traction pour un véhicule électrique de transport, la chaîne de traction comprenant un moteur électrique et un tel convertisseur d'énergie électrique, relié au moteur électrique.

L'invention concerne également un véhicule électrique de transport, tel qu'un véhicule ferroviaire, comprenant une telle chaîne de traction, configurée pour provoquer un déplacement du véhicule.

Le convertisseur d'énergie électrique comprend deux premières bornes associées à la première énergie électrique, au moins une deuxième borne associée à la deuxième énergie électrique, et P bras de commutation, P étant un nombre entier supérieur ou égal à 1, chaque bras de commutation comportant deux demi-bras de commutation connectés en série entre les deux premières bornes et reliés entre eux en un point intermédiaire, le point intermédiaire étant relié à une deuxième borne respective. Chaque demi-bras de commutation comporte N demi-branches de commutation connectées en parallèle, N étant un nombre entier supérieur ou égal à 2, chaque demi-branche de commutation comportant un interrupteur.

L'invention s'applique au domaine du transport, en particulier du transport ferroviaire, notamment aux véhicules de traction électriques, tels que les locomotives et les automotrices.

On connait du document US 2013/0039100 A1 un convertisseur d'énergie électrique du type précité. Le convertisseur d'énergie électrique est un onduleur apte à convertir une énergie continue en une énergie alternative triphasée pour alimenter un moteur électrique triphasé. Le convertisseur d'énergie électrique comprend deux premières bornes associées à l'énergie continue, trois deuxièmes bornes associées à l'énergie alternative triphasée, et trois bras de commutation, chaque bras de commutation comportant deux demi-bras de commutation connectés en série entre les deux premières bornes et reliés entre eux en un point intermédiaire, le point intermédiaire étant relié à une deuxième borne respective.

Chaque demi-bras de commutation comporte deux demi-branches de commutation connectées en parallèle, ou respectivement trois demi-branches de commutation suivant le mode de réalisation considéré, chaque demi-branche de commutation comportant un interrupteur formé d'un transistor et d'une diode connectée en antiparallèle du transistor.

Le convertisseur d'énergie électrique comprend en outre une unité de commande des trois bras de commutation, l'unité de commande étant configurée pour déphaser la commutation d'un bras par rapport à l'autre, afin de délivrer l'énergie alternative triphasée en sortie du convertisseur d'énergie électrique.

Toutefois, les commutations des bras de commutation ne sont pas toujours optimales.

La présente invention a donc pour but de proposer un convertisseur d'énergie électrique permettant d'améliorer la commutation au sein de chaque bras de commutation.

A cet effet, l'invention a pour objet un convertisseur d'énergie électrique du type précité, dans lequel le convertisseur d'énergie électrique comprend en outre 2xP modules de commande, chaque module de commande étant configuré pour commander les interrupteurs d'un demi-bras de commutation respectif, chaque module de commande comportant une borne de sortie pour chaque interrupteur respectif, chaque borne de sortie étant configurée pour délivrer un signal de commande pour ledit interrupteur respectif.

Le convertisseur d'énergie électrique selon l'invention comprend alors un module de commande pour chaque demi-bras de commutation, chaque module de commande étant configuré pour commander les interrupteurs d'un demi-bras de commutation respectif, chaque module de commande comportant une paire de bornes de sortie pour chaque interrupteur respectif, chaque paire de bornes de sortie étant alors apte à délivrer un signal de commande spécifique pour ledit interrupteur respectif.

Le convertisseur d'énergie électrique selon l'invention permet ainsi de délivrer un signal de commande spécifique pour chaque interrupteur respectif, ce qui permet d'améliorer la commutation au sein de chaque bras de commutation.

Suivant d'autres aspects avantageux de l'invention, le convertisseur d'énergie électrique comporte l'une ou plusieurs des caractéristiques suivantes, prises isolément ou suivant toutes les combinaisons techniquement possibles :
- au moins un module de commande est configuré en outre pour synchroniser les commutations des interrupteurs d'un demi-bras de commutation respectif ;
- chaque module de commande qui est apte à synchroniser les commutations des interrupteurs d'un demi-bras de commutation respectif est configuré pour piloter la délivrance des signaux de commandes desdits interrupteurs en fonction de délais de commutation prédéfinis, un délai de commutation prédéfini étant associé à chacun des interrupteurs dudit demi-bras de commutation ;

- le convertisseur d'énergie électrique comprend une boucle de commande respective pour chaque interrupteur, chaque boucle de commande étant connectée entre une borne de sortie respective et l'interrupteur correspondant, et comportant deux condensateurs et deux organes de commutation pour commuter l'interrupteur correspondant dans un état parmi un état d'ouverture et un état de fermeture ;
- au moins un interrupteur est un interrupteur bidirectionnel ;
- chaque interrupteur bidirectionnel comporte un transistor et une diode connectée en antiparallèle du transistor ;
- au moins un transistor est réalisé en carbure de silicium ;
- au moins un transistor est un transistor à effet de champ,
   de préférence un transistor à effet de champ à grille isolée ;
- le nombre P de bras de commutation est égal à 3 ; et
- le nombre N est égal à 3.

L'invention a également pour objet une chaîne de traction pour un véhicule électrique de transport, la chaîne de traction comprenant un moteur électrique et un convertisseur d'énergie électrique relié au moteur électrique, le convertisseur d'énergie électrique étant tel que défini ci-dessus.

L'invention a également pour objet une véhicule électrique de transport, tel qu'un véhicule ferroviaire, comprenant une chaîne de traction configurée pour provoquer un déplacement du véhicule, la chaîne de traction étant telle que définie ci-dessus.

Ces caractéristiques et avantages de l'invention apparaîtront à la lecture de la description qui va suivre, donnée uniquement à titre d'exemple non limitatif, et faite en référence aux dessins annexés, sur lesquels :
- la figure 1 est une représentation schématique d'un véhicule électrique de transport, tel qu'un véhicule ferroviaire, comprenant une chaîne de traction, la chaîne de traction comportant un moteur électrique et un convertisseur d'énergie électrique relié au moteur électrique ;
- la figure 2 est une représentation schématique du convertisseur d'énergie électrique de la figure 1, le convertisseur étant configuré pour convertir une première énergie électrique en une deuxième énergie électrique, et comprenant deux premières bornes associées à la première énergie électrique, trois deuxièmes bornes associées à la deuxième énergie électrique, et trois bras de commutation connectés en parallèle entre les deux premières bornes ; et
- la figure 3 est une représentation schématique de l'un des bras de commutation de la figure 2.

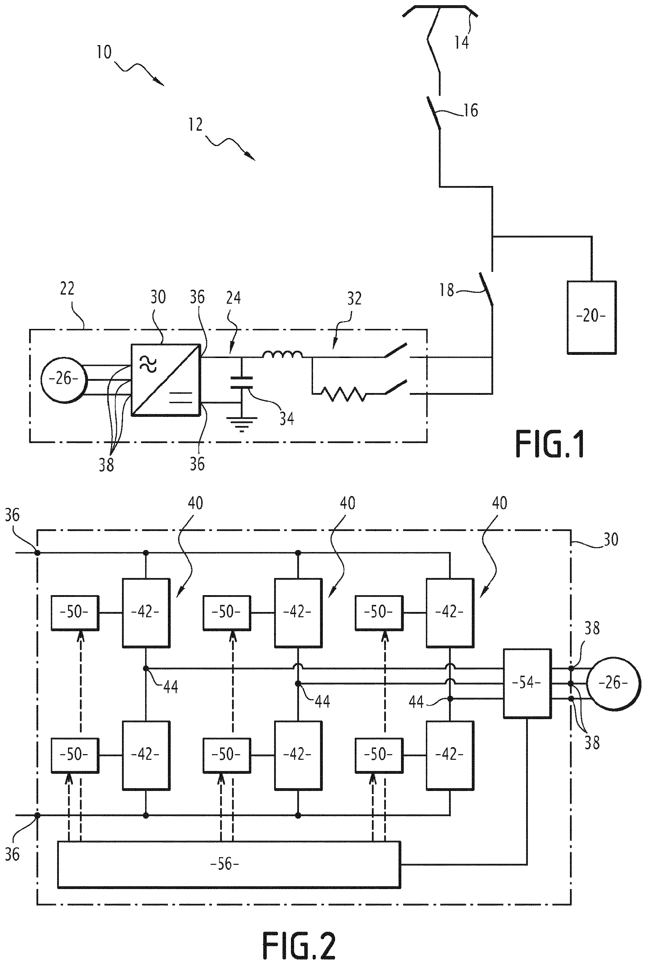

Sur la figure 1, un véhicule électrique de transport 10, tel qu'un véhicule ferroviaire, comprend une chaîne de traction 12, la chaîne de traction comportant un pantographe 14 apte à être connecté à une caténaire, non représentée.

La chaîne de traction 12 comprend un commutateur électrique 16 connecté au pantographe 14 et un disjoncteur électrique 18 connecté au commutateur électrique 16. La chaîne de traction 12 comprend, en complément facultatif, un équipement auxiliaire 20 connecté entre le commutateur électrique 16 et le disjoncteur électrique 18, en dérivation par rapport au disjoncteur électrique 18.

Le commutateur électrique 16, le disjoncteur électrique 18 et l'équipement auxiliaire 20 sont connus en soi, et ne sont pas décrits plus en détail. L'équipement auxiliaire 20 est par exemple un convertisseur statique.

L'ensemble de traction 22 est connecté au disjoncteur électrique 18 via un bus continu 24. L'ensemble de traction 22 comporte un moteur électrique 26, un convertisseur d'énergie électrique 30 relié au moteur électrique 26. Dans l'exemple de la figure 1, le convertisseur d'énergie électrique 30 est destiné à délivrer une tension alternative au moteur 26 à partir d'une tension continue issue du bus continu 24.

En complément, l'ensemble de traction 22 comporte un dispositif de filtrage 32, comportant notamment un condensateur de filtrage 34.

En complément facultatif, l'ensemble de traction 22 comporte un appareil de stockage d'énergie électrique, non représenté, l'appareil de stockage d'énergie électrique étant également appelé coffre d'autonomie, et servant, d'une part, de source d'alimentation auxiliaire, et d'autre part, à récupérer de l'énergie électrique lors d'un freinage du véhicule électrique de transport 10. L'appareil de stockage d'énergie électrique est par exemple connecté en dérivation, entre le disjoncteur électrique 18 et le condensateur de filtrage 34.

Le moteur électrique 26 est par exemple un moteur alternatif, tel qu'un moteur triphasé.

Le convertisseur d'énergie électrique 30 est configuré pour convertir une première énergie électrique en une deuxième énergie électrique.

Dans l'exemple de la figure 2, le convertisseur d'énergie électrique 30 est configuré pour convertir une énergie continue associée au bus continu 24 en une énergie alternative, telle qu'une énergie triphasée, associée au moteur électrique 26. La première énergie électrique est alors l'énergie continue, et la deuxième énergie électrique est l'énergie alternative, telle que l'énergie triphasée.

Le convertisseur d'énergie électrique 30 comprend deux premières bornes 36 associées à la première énergie électrique, au moins une deuxième borne 38 associée à la deuxième énergie électrique, et P bras de commutation 40, P étant un nombre entier supérieur ou égal à 1.

Dans l'exemple de la figure 2, le convertisseur d'énergie électrique 30 est un convertisseur d'énergie continue en en énergie alternative triphasée, et comprend alors trois deuxièmes bornes 38 et trois bras de commutation 40, à savoir une deuxième borne 38 et un bras de commutation 40 pour chaque phase de l'énergie triphasée. Autrement dit, le nombre P de bras de commutation 40 est ici égal à 3.

Chaque bras de commutation 40 comporte deux demi-bras de commutation 42 connectés en série entre les deux premières bornes 36 et reliés entre eux en un point intermédiaire 44, le point intermédiaire 44 étant relié à une deuxième borne 38 respective.

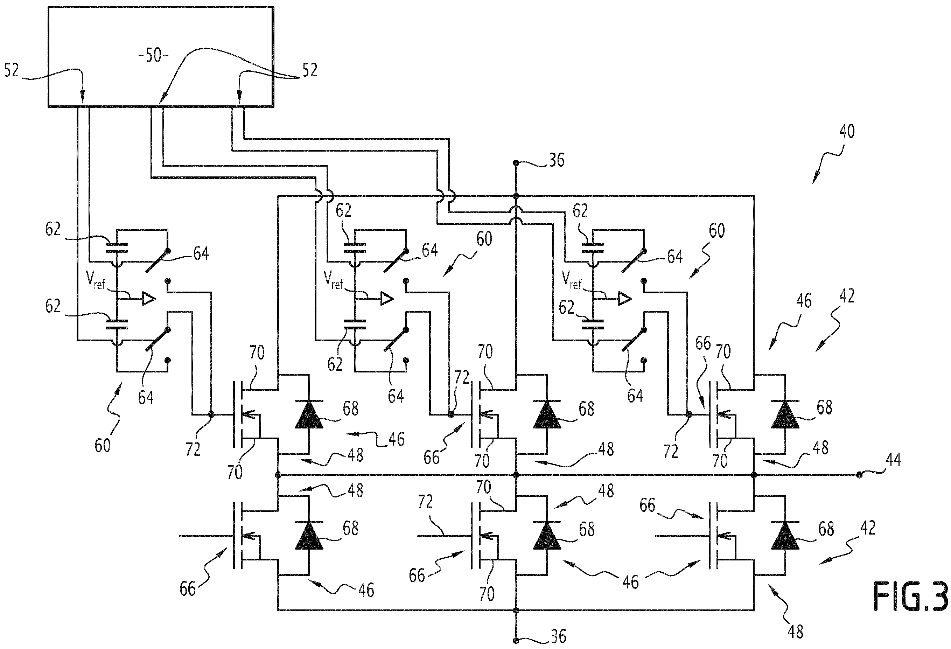

Chaque demi-bras de commutation 42 comporte N demi-branches de commutation 46 connectées en parallèle, N étant un nombre entier supérieur ou égal à 2, chaque demi-branche de commutation 46 comportant au moins un interrupteur 48, comme représenté sur la figure 3. Chaque demi-bras de commutation 42 comporte alors au moins N interrupteurs 48.

Dans l'exemple de la figure 3, chaque demi-bras de commutation 42 comporte trois demi-branches de commutation 46 en parallèle, et le nombre N est alors égal à 3.

Le convertisseur d'énergie électrique 30 comprend en outre 2xP modules de commande 50, chaque module de commande 50 étant configuré pour commander les interrupteurs 48 d'un demi-bras de commutation 42 respectif, comme représenté sur la figure 2. Chaque module de commande 50 comporte une paire de bornes de sortie 52 pour chaque interrupteur 48 respectif, chaque paire de bornes de sortie 52 étant configurée pour délivrer un signal de commande pour ledit interrupteur 48 respectif.

Dans l'exemple de la figure 2, le convertisseur d'énergie électrique 30 comprend alors six modules de commande 50, P étant ici égal à 3, avec un module de commande 50 respectif pour chaque demi-bras de commutation 42.

Le convertisseur d'énergie électrique 30 comprend un dispositif de mesure 54, visible sur la figure 2, configuré pour mesurer au moins une grandeur électrique relative à la deuxième énergie électrique, et un dispositif de pilotage 56 configuré pour piloter les différents modules de commande 50, notamment en fonction de la ou des grandeurs mesurées par le dispositif de mesure 54.

Le convertisseur d'énergie électrique 30 comprend une boucle de commande 60 respective pour chaque interrupteur 48, comme représenté sur la figure 3. Chaque boucle de commande 60 est connectée entre une borne de sortie 52 respective et l'interrupteur 48 correspondant, et comporte deux condensateurs 62 et deux organes de commutation 64 pour commuter l'interrupteur 48 correspondant dans un état parmi un état d'ouverture et un état de fermeture.

L'homme du métier notera que sur la figure 3, seuls le module de commande 50 et les boucles de commande 60 associé à l'un des deux demi-bras de commutation 42 du bras de commutation 40 considéré sont représentés par souci de simplification du dessin, le module de commande 50 et les boucles de commande 60 représentés étant ceux associés au demi-bras de commutation 42 supérieur. Le module de commande 50 et les boucles de commande 60 associés au demi-bras de commutation 42 inférieur ne sont donc pas représentés sur la figure 3.

Dans l'exemple de la figure 3, chaque demi-branche de commutation 46 comporte un seul interrupteur 48.

En variante non représentée, chaque demi-branche de commutation 46 comporte plusieurs interrupteurs 48 connectés en série entre la deuxième borne 36 correspondante et le point intermédiaire 44 respectif. Ceci permet alors de convertir une énergie électrique de tension plus élevée.

Au moins un interrupteur 48 est, par exemple, un interrupteur bidirectionnel. Chaque interrupteur 48 est de préférence un interrupteur bidirectionnel.

Lorsque tous les interrupteurs 48 sont bidirectionnels, le convertisseur d'énergie électrique 30 est alors un convertisseur bidirectionnel configuré pour convertir la première énergie électrique en la deuxième énergie électrique si le courant circule depuis des premières bornes 36 vers la ou les deuxièmes bornes 38, et inversement configuré pour convertir la deuxième énergie électrique en la première énergie électrique si le courant circule depuis la ou les deuxièmes bornes 38 vers les premières bornes 36.

Ce fonctionnement du convertisseur d'énergie électrique 30 en inverse pour convertir la deuxième énergie électrique en la première énergie électrique est notamment utile pour récupérer de l'énergie lors d'un freinage du véhicule électrique de transport 10.

Chaque interrupteur bidirectionnel 48 comporte, par exemple, un transistor 66 et une diode 68 connectée en antiparallèle du transistor 66. Comme connu en soi, chaque transistor 66 comporte deux électrodes de conduction 70 et une électrode de commande 72, chaque transistor 66 étant commandable, via son électrode de commande 72, entre un état parmi un état passant dans lequel le courant circule entre les électrodes de conduction 70, et un état bloqué dans lequel le courant ne circule pas entre les électrodes de conduction 70. La diode 68 est alors connectée entre les électrodes de conduction 70.

En variante, chaque interrupteur bidirectionnel 48 est dépourvu de diode connectée en antiparallèle du transistor, et le transistor est avantageusement un transistor à effet de champ à grille isolée, plus couramment appelé MOSFET.

Au moins un module de commande 50 est, par exemple, configuré en outre pour synchroniser les commutations des interrupteurs 48 d'un demi-bras de commutation 42 respectif. Chaque module de commande 50 est de préférence configuré pour synchroniser les commutations des interrupteurs 48 du demi-bras de commutation 42 auquel il est associé.

Chaque module de commande 50 qui apte à synchroniser les commutations des interrupteurs 48 d'un demi-bras de commutation 42 respectif est configuré pour piloter la délivrance des signaux de commandes desdits interrupteurs 48 en fonction de délais de commutation prédéfinis, un délai de commutation prédéfini étant associé à chacun des interrupteurs 48 dudit demi-bras de commutation 42.

Autrement dit, chaque module de commande 50 est alors propre à délivrer les signaux de commande aux boucles de commande 60, en particulier à leurs organes de commutation 64, ceci de manière décalée d'une boucle de commande 60 à l'autre, en fonction des caractéristiques des interrupteurs 48, en particulier en fonction des délais de commutations prédéfinis qui leur sont associés.

L'homme du métier comprendra alors que chaque module de commande 50 vise à retarder la commutation de l'interrupteur 48 ayant tendance à commuter le plus vite parmi les différents interrupteurs 48 du demi-bras de commutation 42 concerné, et au contraire à commander au plus tôt la commutation de l'interrupteur 48 ayant tendance à commuter le plus lentement parmi lesdits différents interrupteurs 48 de ce demi-bras de commutation 42.

Chaque module de commande 50 est, par exemple, réalisé sous forme d'un composant logique programmable, tel qu'un FPGA (de l'anglais *Field-Programmable Gate Array*). Le convertisseur d'énergie électrique 30 comprend, par exemple, 2xP composants logiques programmables, chacun formant un module de commande 50 respectif. En variante, au moins deux modules de commande 50 sont réalisés sur un seul composant logique programmable, tout en étant distincts avec des bornes de sortie 52 spécifiques pour chaque module de commande 50.

Ces délais de commutation prédéfinis sont par exemple déterminés au cours de tests préliminaires effectués sur les interrupteurs 48, en particulier sur les transistors 66. En effet, ces délais ou temps de commutation sont propres à chaque interrupteur 48, et en particulier à chaque transistor 66, puisqu'ils dépendent de caractéristiques intrinsèques de ces composants, variables d'un composant à l'autre, en particulier d'un transistor 66 à l'autre, et résultant de la fabrication.

Le dispositif de mesure 54 est configuré pour mesurer par exemple l'intensité de chaque courant circulant à travers une deuxième borne 38 respective et/ou la tension en cette deuxième borne 38, c'est-à-dire le courant traversant le deuxième point intermédiaire 44 correspondant et/ou la tension en ce deuxième point intermédiaire 44.

Le dispositif de pilotage 56 est configuré pour piloter les différents modules de commande 50, et ainsi pour commander les différents demi-bras de commutation 42 afin d'effectuer la conversion d'énergie. Le pilotage des modules de commande 50 est notamment effectué en fonction de la ou des grandeurs mesurées par le dispositif de mesure 54.

Chaque boucle de commande 60 est de préférence une boucle essentiellement analogique, où les organes de commutation 64 sont par exemple des transistors, tel que des transistors MOS, et les condensateurs 62 servent à fournir la réserve d'énergie pour piloter l'électrode de commande 72 à la tension adéquate pour la commande du transistor 66 correspondant dans l'état souhaité parmi l'état passant et l'état bloqué.

Chaque boucle de commande 60 présente une très faible longueur, typiquement de l'ordre d'un ou de quelques centimètres.

Chaque boucle de commande 60 a une inductance de très faible valeur, par exemple de l'ordre de quelques dizaines de nH, telle qu'environ 20 nH.

Au moins un transistor 66 est, par exemple, réalisé en carbure de silicium, également appelé SiC (de l'anglais *Silicon Carbide*). Chaque transistor 66 est de préférence réalisé en carbure de silicium.

Au moins un transistor 66 est, par exemple, un transistor à effet de champ, également appelé FET (de l'anglais *Field-Effect Transistor),* de préférence un transistor à effet de champ à grille isolée, plus couramment appelé MOSFET ou transistor à effet de champ à structure métal-oxyde-semiconducteur (de l'anglais *Metal-Oxide Semiconductor Field Effect Transistor*). Chaque transistor 66 est de préférence un transistor MOSFET. Les électrodes de conduction 70 sont alors des électrodes de drain et de source, et l'électrode de commande 72 est une électrode de grille.

En variante, chaque transistor 66 est un transistor bipolaire à grille isolée, également appelé IGBT (de l'anglais *Insulated-Gate Bipolar Transistor*). Les électrodes de conduction 70 sont alors des électrodes de collecteur et d'émetteur, et l'électrode de commande 72 est une électrode de grille.

Ainsi, chaque demi-bras de commutation 42 est commandable de manière indépendante d'un demi-bras de commutation à l'autre, avec un module de commande 50 pour chaque demi-bras de commutation 42 qui est configuré pour commander les interrupteurs 48 de ce demi-bras de commutation 42.

En outre, le fait que chaque module de commande 50 comporte une borne de sortie 52 respective pour chaque interrupteur 48 permet de commander chaque interrupteur 48 de manière individuelle, ce qui autorise une prise en compte des spécificités de chaque interrupteur 48, résultant notamment de leur fabrication.

Cela permet alors d'améliorer la commutation au sein de chaque demi-bras de commutation 42, et donc au sein de chaque bras de commutation 40.

La commutation au sein de chaque demi-bras de commutation 42 est encore améliorée lorsque les modules de commande 50 sont configurés en outre pour synchroniser les commutations des interrupteurs 48 de chaque demi-bras de commutation 42. Cela permet de remédier encore mieux aux disparités intrinsèques entre les interrupteurs 48, en particulier entre les transistors 66, ces disparités étant par exemple inhérentes à la fabrication de ces transistors 66 et se traduisant notamment par des délais, ou temps, de commutation variables d'un interrupteur 48 à l'autre, en particulier d'un transistor 66 à l'autre. Les disparités peuvent aussi être liées à l'action spécifique sur chaque interrupteur 48 du champ généré par les transitions des interrupteurs 48, de l'état passant vers l'état bloqué ou inversement de l'état bloqué vers l'état passant.

Lorsque les transistors 66 sont des transistors réalisés en carbure de silicium, leur commutation est bien plus rapide, ce qui permet d'améliorer encore le fonctionnement du convertisseur d'énergie électrique 30 selon l'invention.

À titre d'exemple, la commutation d'un transistor 66 réalisé en carbure de silicium s'effectue généralement dans un délai compris entre 70 et 100 ns, et est environ 5 à 10 fois plus rapide que celle d'un transistor réalisé en silicium qui s'effectue généralement dans un délai de l'ordre de 500 ms à 1 µs.

On conçoit ainsi que le convertisseur d'énergie électrique 30 selon l'invention permet d'améliorer la commutation au sein de chaque bras de commutation 40.

## Revendications

1. Convertisseur d'énergie électrique (30) configuré pour convertir une première énergie électrique en une deuxième énergie électrique, comprenant :
- deux premières bornes (36) associées à la première énergie électrique ;
- au moins une deuxième borne (38) associée à la deuxième énergie électrique ;
- P bras de commutation (40), P étant un nombre entier supérieur ou égal à 1, chaque bras de commutation (40) comportant deux demi-bras de commutation (42) connectés en série entre les deux premières bornes (36) et reliés entre eux en un point intermédiaire (44), le point intermédiaire (44) étant relié à une deuxième borne (38) respective,
chaque demi-bras de commutation (42) comportant N demi-branches de commutation (46) connectées en parallèle, N étant un nombre entier supérieur ou égal à 2, chaque demi-branche de commutation (46) comportant au moins un interrupteur (48),
**caractérisé en ce que** le convertisseur d'énergie électrique (30) comprend en outre 2xP modules de commande (50), chaque module de commande (50) étant configuré pour commander les interrupteurs (48) d'un demi-bras de commutation (42) respectif, chaque module de commande (50) comportant une borne de sortie (52) pour chaque interrupteur (48) respectif, chaque borne de sortie (52) étant configurée pour délivrer un signal de commande pour ledit interrupteur (48) respectif, et
**en ce que** le convertisseur d'énergie électrique (30) comprend une boucle de commande (60) respective pour chaque interrupteur (48), chaque boucle de commande (60) étant connectée entre une borne de sortie (52) respective et l'interrupteur (48) correspondant, et comportant deux condensateurs (62) et deux organes de commutation (64) pour commuter l'interrupteur (48) correspondant dans un état parmi un état d'ouverture et un état de fermeture.

2. Convertisseur d'énergie électrique (30) selon la revendication 1, dans lequel au moins un module de commande (50) est configuré en outre pour synchroniser les commutations des interrupteurs (48) d'un demi-bras de commutation (42) respectif.

3. Convertisseur d'énergie électrique (30) selon la revendication 2, dans lequel chaque module de commande (50) qui est apte à synchroniser les commutations des interrupteurs (48) d'un demi-bras de commutation (42) respectif est configuré pour piloter la délivrance des signaux de commandes desdits interrupteurs (48) en fonction de délais de commutation prédéfinis, un délai de commutation prédéfini étant associé à chacun des interrupteurs (48) dudit demi-bras de commutation (42).

4. Convertisseur d'énergie électrique (30) selon l'une quelconque des revendications précédentes, dans lequel au moins un interrupteur (48) est un interrupteur bidirectionnel.

5. Convertisseur d'énergie électrique (30) selon la revendication 4, dans lequel chaque interrupteur (48) bidirectionnel comporte un transistor (66) et une diode (68) connectée en antiparallèle du transistor (66).

6. Convertisseur d'énergie électrique (30) selon la revendication 5, dans lequel au moins un transistor (66) est réalisé en carbure de silicium.

7. Convertisseur d'énergie électrique (30) selon la revendication 5 ou 6, dans lequel au moins un transistor (66) est un transistor à effet de champ, de préférence un transistor à effet de champ à grille isolée.

8. Convertisseur d'énergie électrique (30) selon l'une quelconque des revendications précédentes, dans lequel le nombre P de bras de commutation (40) est égal à 3.

9. Convertisseur d'énergie électrique (30) selon l'une quelconque des revendications précédentes, dans lequel le nombre N est égal à 3.

10. Chaîne de traction (12) pour un véhicule électrique de transport (10), la chaîne de traction (12) comprenant un moteur électrique (26) et un convertisseur d'énergie électrique (30) relié au moteur électrique (26),
**caractérisé en ce que** le convertisseur d'énergie électrique (30) est selon l'une quelconque des revendications précédentes.

11. Véhicule électrique de transport (10), tel qu'un véhicule ferroviaire, comprenant une chaîne de traction (12) configurée pour provoquer un déplacement du véhicule (10),
**caractérisé en ce que** la chaîne de traction (12) est selon la revendication précédente.
